# EUROPEAN PATENT APPLICATION

(11) **EP 4 535 424 A2**
(43) Date of publication of application: **09.04.2025**
(21) Application number: 24204290.1
(22) Date of filing: 02.10.2024
(51) Int. Cl.: H01L 25/065, H01L 23/538

(54) **HETEROGENEOUS SEMICONDUCTOR INTERCONNECT INTERFACES, SEMICONDUCTOR DIE, PACKAGING AND SIGNAL ROUTING**

(30) Priority: 06.10.2023 US 202363588684 P; 23.09.2024 US 202418893694
(71) Applicant: Jariet Technologies, Inc., Redondo Beach, California 90277 (US)
(72) Inventor: POWELL, Scott Richard, Redondo Beach, 90277 (US); REUTEMANN, Robert Ernst, Redondo Beach, 90277 (US)
(74) Representative: Epping - Hermann - Fischer

(57) **Abstract**

An example semiconductor die includes a set of circuit components, a first interconnect circuit, and a second interconnect circuit, all arranged on a substrate. The first interconnect circuit is configured for a first interface type and includes one or more first signaling components and a first connection interface. The second interconnect circuit includes second signaling component(s) and a second connection interface, and is configured for a second interface type having requirement(s) that differ from requirement(s) of the first interface type. When the first interface type is selected, the first connection interface is electrically coupled to the first signaling components, and the second connection interface is electrically isolated from the second signaling components. When the second interface type is selected, the first connection interface is electrically isolated from the first signaling components, and the second connection interface is electrically coupled to the second signaling components.

## Description

### CROSS-REFERENCE TO RELATED APPLICATIONS

This application claims the benefit of and priority to U.S. Provisional Patent Application No. 63/588,684, filed October 6, 2023, the entire contents of which are incorporated herein by reference for all purposes.

### TECHNICAL FIELD

The disclosed embodiments relate to systems, devices, circuits, dies, semiconductor packaging, and interfaces, including, without limitation, high-speed input/output (I/O) placement on a chiplet and associated packaging, signal routing, and die placement as well as devices, circuits and methods for supporting interoperability of multiple different semiconductor package interfaces.

### BACKGROUND

There are various chiplet design and interconnection options including advanced packaging, such as an advanced universal chiplet interconnect express (UCIe) interface (e.g., using micro bumps). UCIe is an open standard for high-rate digital data communications between multiple dies or chiplets in a single package. The high data rate in UCIe is achieved using parallel interconnection lanes between die on the same package substrate (e.g., each lane caries a portion of a composite digital data bandwidth). The UCIe standard specifies interoperation over two different package types, standard (e.g., using traditional packaging technology) and advanced (e.g., using fine line packaging technology).

There are a variety of different advanced packaging approaches that each have their own issues, including complex processing steps and reliability issues, such as fracturing in thermal cycles and warping. Accordingly, advanced packaging is avoided in some situations and more conventional packaging, such as a standard UCIe interface, is used instead.

However, advanced and standard interfaces (e.g., advanced and standard UCIe interfaces) may be physically incompatible. For example, standard UCIe interfaces cannot interoperate with advanced UCIe interfaces, e.g., due to differences in bump types, bump patterns, signal assignments, packaging technologies, and maximum trace lengths. As an example, the size and pitch along the die edge may be different, as well as the type of bumps used for connecting, and the assumptions about the underlying package/interconnect technology. Therefore, an advanced UCIe interface on one die can only connect to another advanced UCIe interface, but not to a standard UCIe interface (and vice versa).

The description in the background section includes information that describes one or more aspects of the subject technology, and the description in this section does not limit the invention.

### SUMMARY

The present disclosure describes, amongst other things, example semiconductor dies that include both a standard interface and an advanced interface. For example, a semiconductor die may be fabricated with both interfaces and then, based on an intended use of the semiconductor die, one of the interfaces is activated (and the other remains inactive). In some embodiments, activating an interface includes electrically coupling the interface components (e.g., bumps) with corresponding signaling components (e.g., transistors).

In one or more aspects, the subject technology improves technology and solves technical problems, such as providing a single die that can be coupled to other dies or components using both standard and advanced interfaces. In this way, the die may be manufactured/fabricated in advance and then used in systems with either standard or advanced interfaces. For example, one of the interfaces may be selected and activated during the final stages of the fabrication process (e.g., the last metal, passivation, and/or bump steps). This removes the requirement that different dies be designed and manufactured for the two different interfaces.

In accordance with some embodiments, a semiconductor die includes: (i) a set of circuit components having transistors and arranged on a substrate; (ii) a first interconnect circuit having transistors, arranged on the substrate, and configured for a first interface type to connect to a first semiconductor die; and (iii) a second interconnect circuit having transistors, arranged on the substrate, and configured for a second interface type to connect to a second semiconductor die. An interface layer of the first interconnect circuit has a first arrangement of components in accordance with selection of the first interface type. The interface layer of the first interconnect circuit has a second arrangement of components in accordance with selection of the second interface type, the second arrangement being different from the first arrangement.

In accordance with some embodiments, a method of fabricating a semiconductor die includes: (i) arranging a set of circuit components on a substrate; (ii) arranging a first interconnect circuit on the substrate, the first interconnect circuit comprising one or more first signaling components and a first connection interface, where the first interconnect circuit is configured for a first interface type; (iii) electrically coupling the first interconnect circuit to the set of circuit components; (iv) arranging a second interconnect circuit on the substrate, the second interconnect circuit comprising one or more second signaling components, and a second connection interface, where the second interconnect circuit configured for a second interface type, and where the second interface type has one or more requirements that differ from requirements of the first interface type; (v) electrically coupling the second interconnect circuit to the set of circuit components; (vi) in accordance with selection of the first interface type: (a) electrically coupling the first connection interface to the one or more first signaling components; and (b) forgoing electrically coupling the second connection interface to the one or more second signaling components; and (vii) in accordance with selection of the second interface type: (c) electrically coupling the second connection interface to the one or more second signaling components; and (d) forgoing electrically coupling the first connection interface to the one or more first signaling components.

In accordance with some embodiments, a semiconductor die includes: (i) a substrate; (ii) a set of circuit components arranged on the substrate and having transistors; (iii) a first interconnect circuit arranged on the substrate, spaced apart from the set of circuit components along at least one of first and second directions, and electrically coupled to the set of circuit components, the first interconnect circuit configured for a first interface type and comprising: (a) one or more first signaling components having transistors; and (b) a first connection interface disposed on the one or more first signaling components and spaced apart from the one or more first signaling components along a third direction; and (iv) a second interconnect circuit arranged on the substrate, spaced apart from the set of circuit components along at least one of the first and second directions, and electrically coupled to the set of circuit components, the second interconnect circuit configured for a second interface type, the second interface type having one or more requirements that differ from requirements of the first interface type, the second interconnect circuit comprising: (c) one or more second signaling components having transistors; and (d) a second connection interface disposed on the one or more second signaling components and spaced apart from the one or more second signaling components along the third direction. In accordance with selection of the first interface type, the first connection interface is electrically coupled to the one or more first signaling components, and the second connection interface is electrically isolated from the one or more second signaling components. In accordance with selection of the second interface type, the first connection interface is electrically isolated from the one or more first signaling components, and the second connection interface is electrically coupled to the one or more second signaling components.

In accordance with some embodiments, a multi-die package includes: (i) a semiconductor die having two different interconnect circuits as described herein; and (ii) a second semiconductor die electrically coupled to the semiconductor die via one of the interconnect circuits, where the second semiconductor die includes an interconnect configured for an interface type that is same as an interface type of the one of the first interconnect circuit and the second interconnect circuit. The features and advantages described in the specification are not necessarily all-inclusive and, in particular, some additional features and advantages will be apparent to one of ordinary skill in the art in view of the drawings, specification, and claims provided in this disclosure. Moreover, it should be noted that the language used in the specification has been principally selected for readability and instructional purposes and has not necessarily been selected to delineate or circumscribe the subject matter described herein. Nothing in this section should be taken as a limitation on those claims. Further aspects and advantages are discussed below in conjunction with example embodiments of the present disclosure.

It is to be understood that both the foregoing description and the following description of the present disclosure are examples, and are intended to provide further explanation of the disclosure as claimed.

### BRIEF DESCRIPTION OF THE DRAWINGS

So that the present disclosure can be understood in greater detail, a more particular description can be had by reference to the features of various embodiments, some of which are illustrated in the appended drawings. The appended drawings, however, merely illustrate pertinent features of the present disclosure and are therefore not necessarily to be considered limiting, for the description can admit to other effective features as the person of skill in this art will appreciate upon reading this disclosure.
Figure ("FIG.") 1 illustrates a top-down plan view of an example semiconductor die with multiple different semiconductor interconnect interfaces (e.g., a standard UCIe interface and an advanced UCIe interface) in accordance with some embodiments.
Figure 2A illustrates a top-down plan view of an example multi-die package having semiconductor dies with multiple different semiconductor interconnect interfaces connected to another component utilizing a first interconnect interface (e.g., a standard UCIe interface) in accordance with some embodiments.
Figure 2B illustrates a top-down plan view of an example multi-die package having semiconductor dies with multiple different semiconductor interconnect interfaces connected to another component utilizing a second interconnect interface (e.g., an advanced UCIe interface) in accordance with some embodiments.
Figure 3A illustrates a top-down plan view of another example multi-die package having semiconductor dies with multiple different semiconductor interconnect interfaces connected to another component utilizing a first interconnect interface (e.g., a standard UCIe interface) in accordance with some embodiments.
Figure 3B illustrates a top-down plan view of another example multi-die package having semiconductor dies with multiple different semiconductor interconnect interfaces connected to another component utilizing a second interconnect interface (e.g., an advanced UCIe interface) in accordance with some embodiments.
Figure 4A illustrates a perspective view of an example multi-die package having semiconductor dies with multiple different semiconductor interconnect interfaces connected to another component in accordance with some embodiments.
Figure 4B illustrates a cross-sectional view of the example multi-die package shown in Figure 4A in accordance with some embodiments.
Figure 5A illustrates a cross-sectional view of a portion of an example interface that is in an active mode in accordance with some embodiments.
Figure 5B illustrates a cross-sectional view of a portion of an example interface that is in an inactive mode in accordance with some embodiments.
Figure 6 illustrates an example die fabrication process in accordance with some embodiments.

In accordance with common practice, the various features illustrated in the drawings are not necessarily drawn to scale, and like reference numerals can be used to denote like features throughout the specification and figures.

### DETAILED DESCRIPTION

The present disclosure describes example semiconductor dies, and associated methods of manufacturing/fabrication, having both standard and advanced interfaces. The example semiconductor dies may include redundant connections where only one of the connections is selected/activated. The inactive interface(s) may be powered down (e.g., with little or no power provided to the inactive interface). For example, a semiconductor die may have common connections that are shared by both interfaces. In some embodiments, the example semiconductor die has a symmetric configuration such that the die may be rotated and coupled in different orientations. In some embodiments, multi-die connections are created using partial interface connection (e.g., a first die and a second die are coupled to portions of an interface of a third die). In some embodiments, the active interface and the inactive interface(s) use a same bump pattern (e.g., with the inactive interface(s) using dummy bumps).

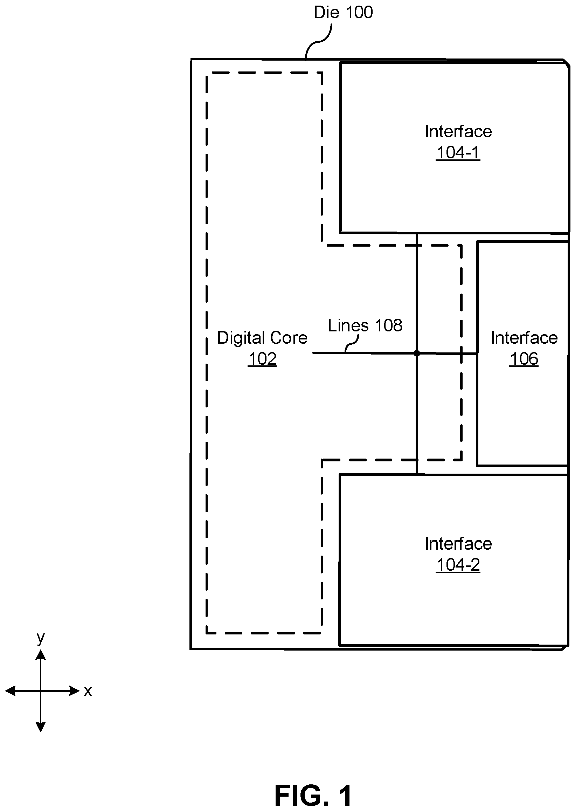

Turning now to the figures, Figure 1 illustrates a top-down plan view of a semiconductor die 100 with a digital core 102 (e.g., including a set of transistors), a set of interfaces 104 having a first interface type (e.g., a standard UCIe type interface), and an interface 106 having a second interface type (e.g., an advanced UCIe type interface). The interfaces 104 and 106 are connected to the digital core 102 via lines 108 (e.g., one or more traces, buses, and/or other types of connectors). In the example of Figure 1, the set of interfaces 104 includes interface 104-1 and interface 104-2. In some embodiments, the set of interfaces 104 includes more or less than two interfaces (e.g., 1, 3, or 4). In some embodiments, the die 100 includes more than one interface 106 (e.g., 2, 3, or 4). In some embodiments, the interface 106 includes multiple modules (e.g., 8 modules). In some embodiments, each interface 104 includes multiple modules (e.g., 2 modules). Each module (within its respective interface) may be identical in structure but may carry different signals. Each of the modules may provide, for example, 32 channels (or lanes) for transmitting and receiving signals. The signals may include, for example, data signals, control signals, power and/or ground. The die may be an electronic device, such as a high-speed transceiver. The foregoing is an example, and the subject technology is not limited thereto.

In some embodiments, the interface 104-1 represents one half of a complete interface and the interface 104-2 represents the other half. For example, the die 100 is coupled to another die via the set of interfaces 104 with one half of the connections connected to the interface 104-1 and the other half of the connections connected to the interface 104-2. In some embodiments, the die 100 includes additional components not shown in Figure 1. For example, the die 100 may include one or more analog components, one or more additional interfaces, and/or other components. In some embodiments, the die 100 has different dimensions and/or a different size. For example, the die 100 may extend further left than is shown in Figure 1.

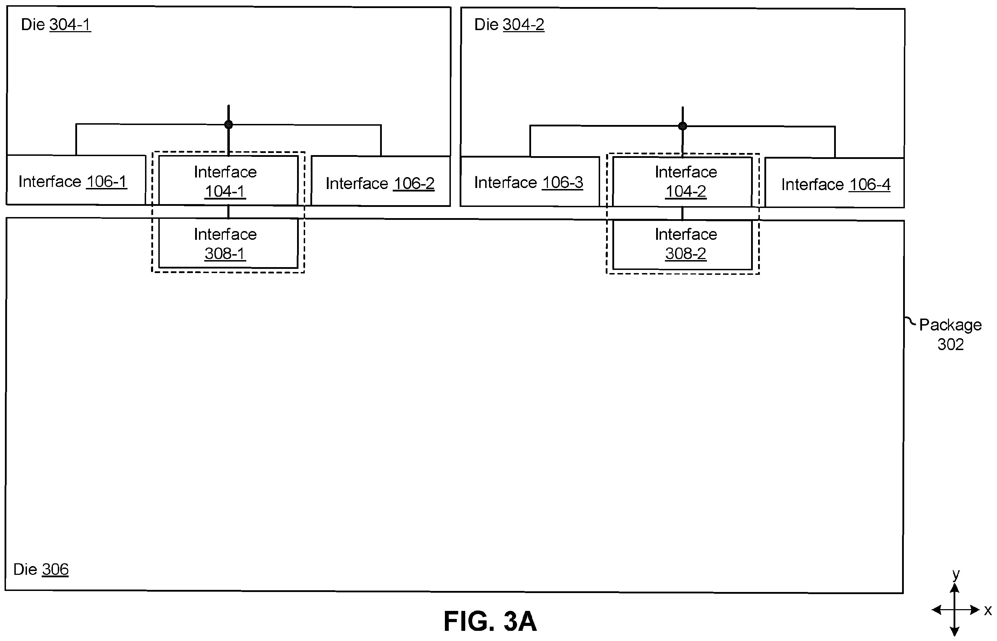

In Figure 1, the die 100 has at least three areas: a first area corresponding to the interfaces 104 (e.g., and configured for (configured to support) a standard UCIe interface), a second area corresponding to the interface 106 (e.g., and configured for (configured to support) an advanced UCIe interface), and a third area corresponding to the digital core 102 (e.g., configured to utilize the interfaces 104 and 106). As an example, the first area corresponding to the interface 104 has two sub-areas, a first upper area corresponding to the interface 104-1 and a first lower area corresponding to the interface 104-2. In another example, the second area corresponding to the interface 106 may have two areas, a second upper area and a second lower area, (e.g., as shown on the dies 304 in Figure 3A).

In an example in which the interfaces 104 are configured for standard UCIe connections, the first area may be referred to as a standard area. Additionally, the first upper area and the first lower area for a standard UCIe interface may be sometimes referred to as a standard upper area and a standard lower area. In an example in which the interface 106 is configured for advanced UCIe connections, the second area may be referred to as an advanced area. Additionally, the second upper area and the second lower area for an advanced UCIe interface may be sometimes referred to as an advanced upper area and an advanced lower area. In one or more aspects, an area or a region may refer to one or more areas or one or more regions.

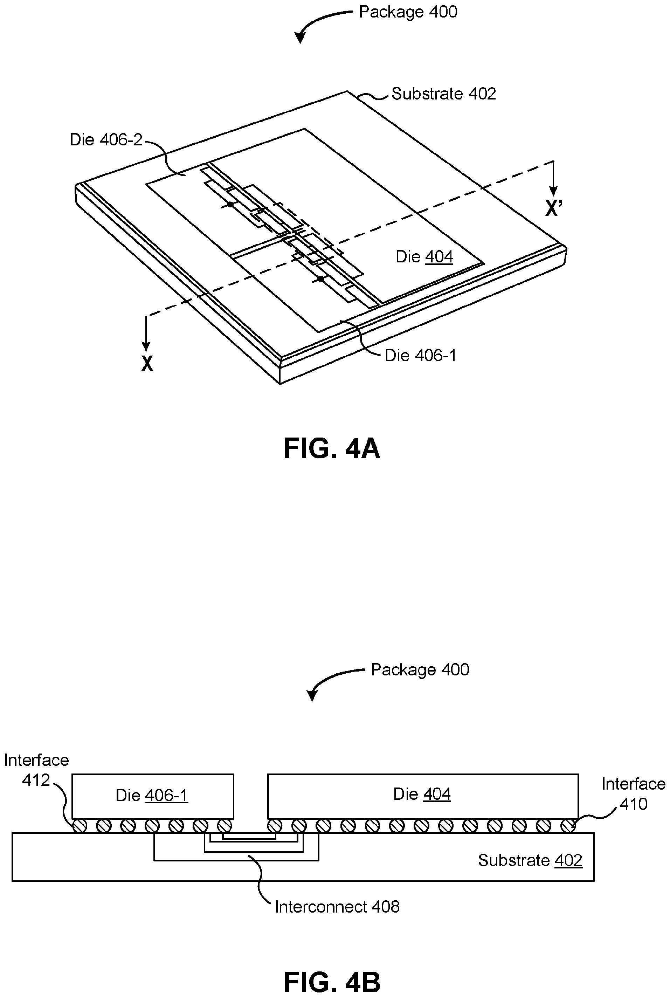

In some embodiments, the die 100 includes a plurality of bumps for connecting the die 100 to a package or other component. For example, the die 100 may include on-die bump array(s) configured to connect the die to a common substrate or other component using flip-chip packaging techniques. Referring to Figure 1, any or all of the three areas may have bumps (e.g., bump arrays). These bumps may be disposed at the bottom of the die 100 (e.g., as illustrated by interface 412 of die 406-1 in Figure 4B). An advanced UCIe interface is more advanced than other interfaces, such as the standard UCIe interface and, compared to a standard area for the standard UCIe interface (and/or the digital core area), an advanced area for the advanced UCIe interface may have a smaller bump pitch, a narrower bump width, and the ability to carry signals with higher data rates.

The die may have various circuits (e.g., transistors, capacitors) in the digital core 102. The digital core 102 may be coupled to and/or be adjacent to at least a portion of each of the interfaces 104 and 106. For example, the circuits in the digital core area may be coupled to conductive lines (e.g., the lines 108) for carrying signals. The conductive lines from the digital core area may be coupled to some of the conductive lines in the standard and advanced areas. The conductive lines can be used to communicate between the digital core 102 and the interfaces 104 (e.g., the standard UCIe interface) and between the digital core 102 and the interface 106 (e.g., the advanced UCIe interface). As an example, when the same signals are used for the interfaces 104 and 106, conductive lines for the same signals may be shared by both interfaces. In the example of Figure 1 in which the interfaces 104 include the interface 104-1 and the interface 104-2, the signals for the interfaces 104 may be split so that a half of the signals are directed to the interface 104-1 (e.g., the standard upper area), and the other half of the signals are directed to the interface 104-2 (e.g., standard lower area). As another example, the signals for the interface 106 are directed to the advanced area.

For example, if there are 50 common signals for both the interfaces 104 and 106, 30 standard signals for the interfaces 104, and 10 advanced signals for the interface 106, then one half of the 50 common signals and one half of the 30 standard signals are selectively directed to the interface 104-1 (e.g., the standard upper area), the other half of the 50 common signals and the other half of the 30 standard signals are selectively directed to the interface 104-2; and the 50 common signals and the 10 advanced signals are selectively directed to the interface 106. In this example, the lines 108 from the digital core 102 may include 50 common conductive lines for the 50 common signals, 30 conductive lines for the 30 standard signals, and 10 conductive lines for the 10 advanced signals. The portion of the lines 108 for the interface 104-1 includes half of the 50 common signals and half of the 30 standard signals. The portion of the lines 108 for the interface 104-2 includes the other half of the 50 common signals and the other half of the 30 standard signals. The portion of the lines 108 for the interface 106 includes the 50 common signals and the 10 advanced signals.

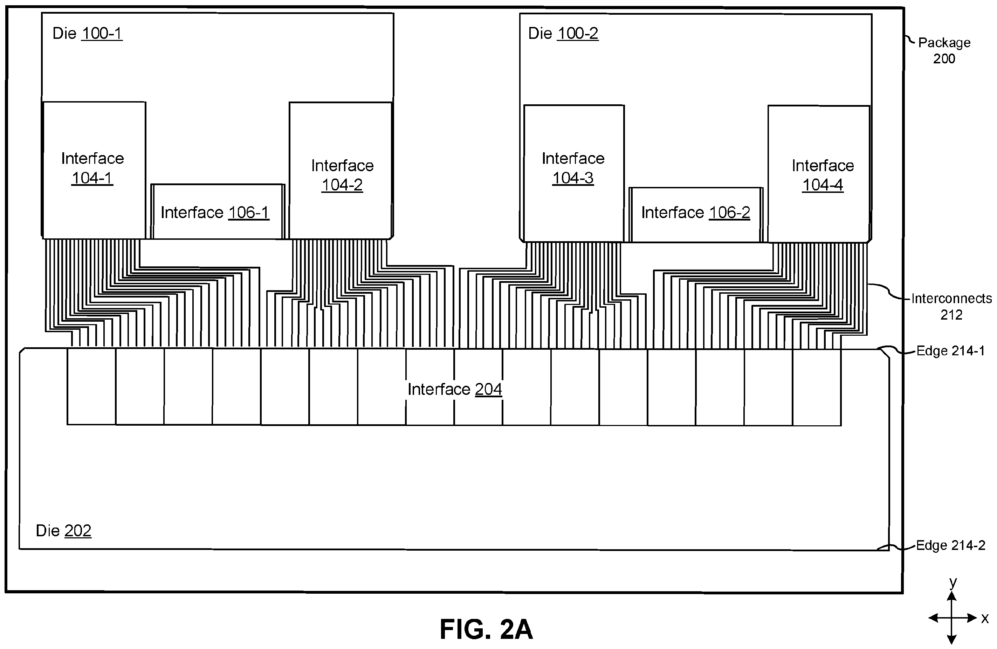

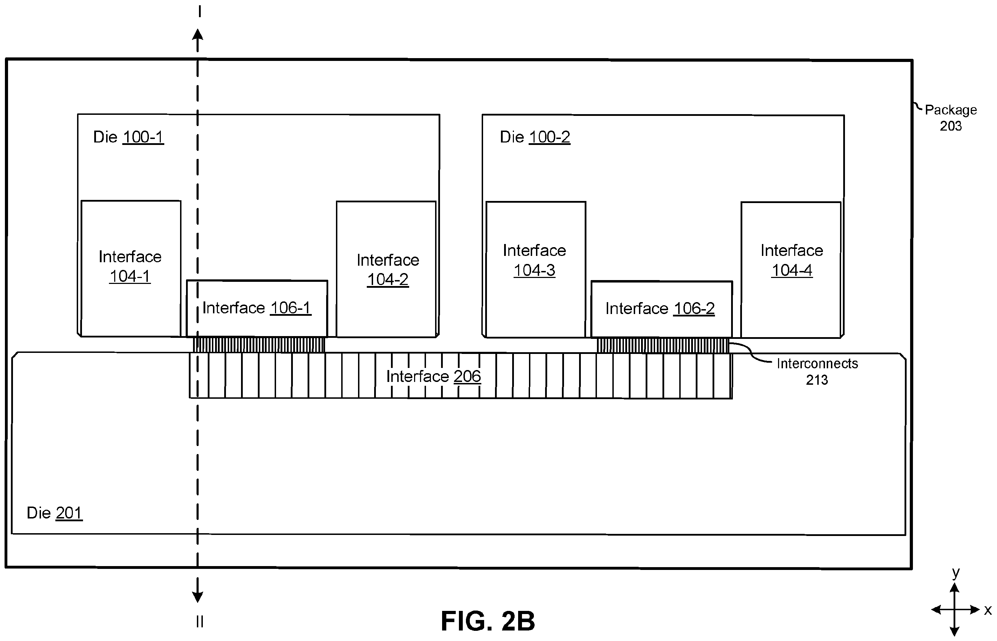

The die 100 or the digital core 102 may include, for example, a demultiplexer (not shown) for routing signals from the digital core 102 to the interfaces 104 or the interface 106 and a multiplexer (not shown) for routing signals from the interfaces 104 or the interface 106 to the digital core 102. In an example, a demultiplexer and a multiplexer may be disposed in the digital core area adjacent to the standard and advanced areas. In one or more aspects, the interfaces 104 (e.g., a standard UCIe interface) or the interface 106 (e.g., an advanced UCIe interface) is selected depending on the type of interface utilized by a target component (e.g., a host die (e.g., the die 202 in Figure 2A), a target device to which the die 100 is to be connected, or other type of component). For example, if the target component uses a standard UCIe interface, a standard UCIe interface is selected for die 100 (e.g., as illustrated in Figure 2A). If the target component uses an advanced UCIe interface, an advanced UCIe interface is selected for the die 100 (e.g., as illustrated in Figure 2B). In one or more aspects, while the die 100 physically includes both the interfaces 104 and 106, the die 100 selects only one (not both) of the interfaces 104 and 106 for an active mode.

In an example, when the interface 106 (e.g., an advanced interface) is selected and thus is in an active mode (e.g., as shown in Figure 2B), the demultiplexer may route signals from the digital core 102 to the interface 106 but not to the interfaces 104 (e.g., the standard areas), and the multiplexer may route signals to the digital core 102 from the interface 106 but not from the interfaces 104. In another example, when the interface(s) 104 (e.g., a standard UCIe interface) are selected and thus in an active mode (e.g., as shown in Figure 2A), then the demultiplexer may route signals from the digital core 102 to the interface(s) 104 but not to the interface 106, and the multiplexer may route signals to the digital core 102 from the interface(s) 104 but not from the interface 106.

Referring to, for example, Figures 2A-2B and 3A-3B, one or more interfaces 104 and one or more interface 106 may be provided in a die (e.g., the die 100 or a die 304) adjacent to a side edge of the die, where the side edge of the die is to be adjacent to a side edge of a target die (e.g., die 201, die 202, die 306, or die 306) to which the die is to be connected.

Figure 2A illustrates a top-down plan view of a multi-die package 200 having semiconductor dies 100 with multiple different interconnect interfaces (e.g., the interfaces 104 and 106) connected to a die 202 utilizing the interfaces 104 (e.g., a standard UCIe interface) in accordance with some embodiments. In some embodiments, the die 202 is an FPGA or ASIC die. In some embodiments, the die 202 is replaced with a different type of component. The dies 100-1 and 100-2 each include an interface 106 (e.g., an advanced area) and interfaces 104 (e.g., standard areas). In the example of Figure 2A, each die 100 includes two interfaces 104 (e.g., the interfaces 104-1 and 104-2 for the die 100-1, and the interfaces 104-3 and 104-4 for the die 100-2). In the example of Figure 2A, the die 202 includes only one interface 204 (e.g., a standard UCIe interface). In this example, because the die 202 uses the interface 204 (e.g., a standard UCIe interface), during a final stage of the fabrication process of dies 100-1 and 100-2, the interfaces 104 are selected to be in an active mode. Therefore, as described in more detail below, the inactive interfaces 106 may have dummy bumps that are not electrically connected to the interface components. While the dummy bumps may be used for mechanical purposes, they are not used for transmitting or receiving signals. The dummy bumps may be electrically isolated from at least some of their underlying interconnects and components and at least some of the transistors in the digital core area. An electrical connection path between the dies 100 and the die 202 may include, among others, (a) the bumps in the standard areas disposed at the bottom of each die 100, (b) the package interconnects 212 (e.g., standard package interconnects using a silicon interposer or silicon bridge) at or in the package substrate, and (c) the bumps in the area(s) of the interface 204 of the die 202 (e.g., disposed at the bottom of the die 202 as illustrated in Figure 4B).

As the placement of the interfaces 104 and 106 in each die 100 is symmetric (e.g., with respect to a line parallel to a y-axis and crossing a middle region of the die 100), various die connection configurations are possible. For example, while Figure 2B illustrates the dies 100 and 202 in an orientation in which the bottom-side edges of the dies 100 face edge 214-1 (e.g., the top-side edge) of die 202, in another example, a multi-die package may include additional dies 100 (not shown). For example, additional dies 100 may be rotated 180 degrees and placed to the bottom of the die 202 so that the top-side edges of the additional dies 100 may face edge 214-2 (e.g., the bottom-side edge) of the die 202, and the additional dies 100 may be mounted on the package substrate and connected to the die 202. In this example, the die 202 may include a second interface 204 (e.g., for a standard UCIe interface) at its bottom-side edge (not shown), in a manner similar to the interface 204 at its top-side edge. In this example, the multi-die package includes the dies 100-1, 100-2, 202, and the additional dies 100 (not shown) all mounted on a package substrate.

Further, in another example, two identical dies may be connected to each other. For example, die 100-1 may be connected to die 100-2 that has been rotated 180 degrees, where the two dies may be connected to each other using a package substrate, and the two dies may be disposed on the package substrate.

In some embodiments, when a die is rotated 180 degrees, the symmetry of the placement of the advanced and standard areas is maintained (e.g., with respect to a line parallel to an x-axis and crossing a middle region of a die). However, the order of some of the elements may be reversed. For example, referring back to Figure 1, when the die is rotated 180 degrees, the standard upper area corresponding to the interface 104-1 becomes a standard lower area, and the standard lower area corresponding to interface 104-2 becomes a standard upper area, but the advanced area corresponding to interface 106 is maintained as an advanced area as it is located in a middle region. Further, with respect to the y-axis, an upper bump in the advanced area may become a lower bump in the advanced area after the 180-degree rotation. Similarly, with respect to the y-axis, an upper bump in the standard upper area may become a lower bump in a standard lower area.

Figure 2B illustrates a top-down plan view of a multi-die package 203 having semiconductor dies 100 with multiple different semiconductor interconnect interfaces connected to a die 201 utilizing an interconnect interface 206 (e.g., an advanced UCIe interface) in accordance with some embodiments. Each of the dies 100 includes an interface 106 (e.g., an advanced area) and interfaces 104 (e.g., standard areas). In the example of Figure 2B, each die 100 includes two interfaces 104 (e.g., the interfaces 104-1 and 104-2 for the die 100-1, and the interfaces 104-3 and 104-4 for the die 100-2). In this example, the die 201 has only the interface 206 (e.g., an advanced UCIe interface). In this example, because the die 202 uses the interface 206 (e.g., an advanced UCIe interface), during a final stage of the fabrication process of dies 100-1 and 100-2, the interfaces 106 are selected to be in an active mode. As described in more detail below, when an advanced area is in an active mode, each standard area may have dummy bumps, and each advanced area may have advanced bumps. The electrical connection path between the dies 100 and the die 201 may include, among others, (a) the bumps in the advanced areas disposed at the bottom of dies 100, (b) advanced package interconnects 213 (e.g., conductive traces between the dies 100 and the die 201) at or on the package substrate, and (c) the bumps in the area(s) of the interface 206 of the die 201 disposed at the bottom of the die 201.

Similar to the description provided with reference to Figure 2A, the multi-die package of Figure 2B may have one or more dies (e.g., the dies 100) and one or more target dies (e.g., the die 201), and as the placement of the interfaces 104 and 106 is symmetric (e.g., with respect to a line parallel to a y-axis and crossing a middle region of a die), various die connection configurations are possible. For example, a multi-die package may have additional dies 100 placed on the bottom side of the die 202 (opposite of the top side where the dies 100-1 and 100-2 are placed). Additionally, two identical dies (e.g., the die 100-1 and the die 100-2) may be connected to each other using a package substrate, where one of the two dies has been rotated 180 degrees.

As mentioned above, in some embodiments, each advanced area (e.g., interface 106) of a die has 8 modules, where each module includes 32 channels. Thus, dies 100-1 and 100-2 together can provide 512 channels (i.e., 8 x 32 x 2 = 512). Dies 100-1 and 100-2 may be identical in structure but may receive different signals. The modules may be identical in structure but may receive different signals. The interface 206 of the die 201 may have two 16 modules. Thus, the die 201 may have a total of 1024 channels (i.e., 2 x 16 x 32 = 1024). In the example of Figure 2B, not all of the 1024 channels are used, rather the die 201 uses up to 512 channels from the two dies 100-1 and 100-2. The foregoing is an example, and the subject technology is not limited thereto. Depending on the size of the dies and interfaces and the application requirements, a multi-die package may have one or more dies (e.g., one or more dies 100) and one or more target dies (e.g., one or more dies 201 or 202). The number of dies 100 may be one or greater than one. Likewise, the number of target dies may be one or greater than one.

A cross sectional view along the line I-II (across the interface 106-1 of die 100-1 and the interface 206 of die 201) of Figure 2B may be similar to the view shown in Figure 4B.

Figure 3A illustrates a top-down plan view of a multi-die package 302 having semiconductor dies 304 with multiple different semiconductor interconnect interfaces connected to a die 306 utilizing the interconnect interface 104 (e.g., a standard UCIe interface) in accordance with some embodiments. Each of the dies 304 includes interfaces 106 (e.g., an advanced area) and an interface 104 (e.g., a standard area). In this example, the interfaces 106 for each die 304 include two interfaces, e.g., interface 106-1 and 106-2 for the dies 304-1. As an example, a larger die (e.g., in which the die size is significantly larger than the interface size) may include multiple instances of an advanced interface (e.g., the interface 106) to solve physical location constraints imposed by a short maximum trace length (e.g., 2 millimeters (mm)). A standard interface may not need multiple instances as the standard interface may have a larger maximum trace length constraint (e.g., 25 mm).

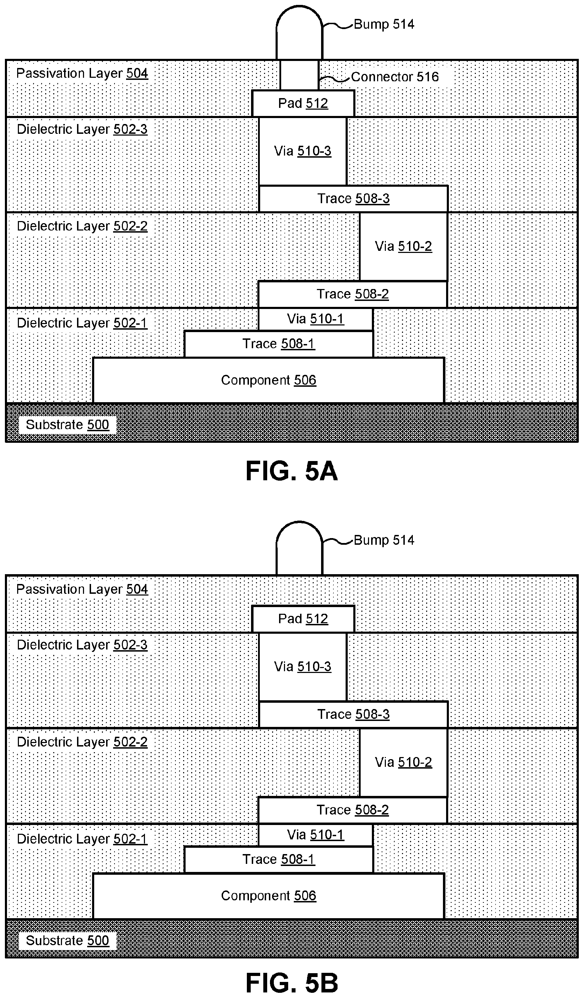

In the example of Figure 3A, as the die 306 uses interfaces 308 (e.g., standard UCIe interfaces), during a final stage of the fabrication process of the dies 304, the interface 104 is selected to be in an active mode. As described above, when a standard area is in an active mode, each standard area may have standard bumps, and each advanced area may have dummy bumps that are, for example, standard bumps or other bumps similar to standard bumps (instead of advanced bumps). While the dummy bumps may be used for mechanical purposes, they are not used for transmitting or receiving signals. The dummy bumps may be electrically insulated (e.g., isolated) from at least some of their underlying interconnects and components (e.g., as described in reference to Figures 5A and 5B). The electrical connection path between the dies 304 and the die 306 may include, among others, (a) the bumps in the standard areas (e.g., corresponding to interfaces 104) disposed at the bottom of the dies 304, (b) the standard package interconnects (e.g., conductive traces on the package substrate) at or on the package substrate, and (c) the bumps in the area(s) of the interfaces 308 of the die 306 disposed at the bottom of die 306. Similar to the description provided with reference to Figure 2A, the multi-die package 302 in Figure 3A may have one or more dies 304 and one or more target dies (e.g., the die 306), and as the placement of the advanced and standard areas is symmetric (e.g., with respect to a line parallel to a y-axis and crossing a middle region of a die), various die connection configurations are possible.

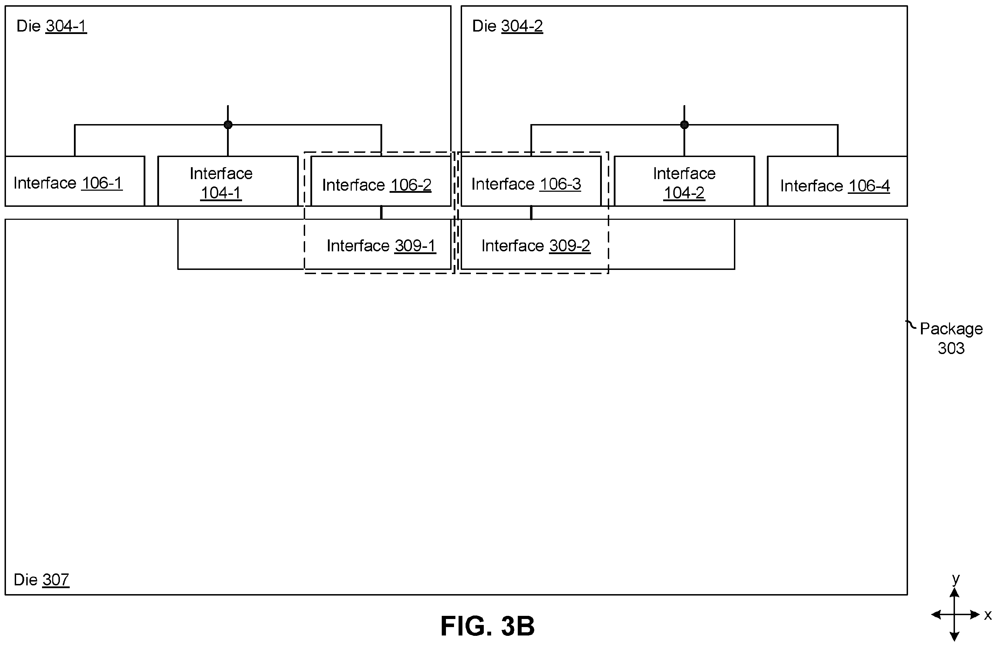

Figure 3B illustrates a top-down plan view of a multi-die package 303 having semiconductor dies 304 with multiple different semiconductor interconnect interfaces (e.g., interfaces 104 and 106) connected to a die 307 utilizing interconnect interfaces 309 (e.g., an advanced UCIe interface) in accordance with some embodiments. Each of the dies 304 includes interfaces 106 (e.g., an advanced area) and an interface 104 (e.g., a standard area). In this example, the interfaces 106 for each die 304 include two interfaces, e.g., interface 106-1 and 106-2 for the dies 304-1. In this example, the die 307 has only interfaces 309 (e.g., advanced UCIe interfaces) present. Because the die 307 uses interfaces 309 (e.g., advanced UCIe interfaces), during a final stage of the fabrication process of the dies 304, an interface 106 (e.g., the interface 106-2) is selected to be in an active mode. In some embodiments, the interface 106-2 is selected (e.g., instead of the interface 106-1) for the die 304-1 based on a planned orientation of the die 304-1. In some embodiments, the interface(s) 106 that are in an inactive mode (e.g., the interface 106-1 for the die 304-1, and the interface 106-4 for the die 304-2) do not receive signals from the digital core area and do not send signals to the digital core area.

In the particular example of Figure 3B, the interface 106-2 of the die 304-1 and the interface 106-3 of the die 304-2 are selected to be in an active mode and the interface 106-1 of the die 304-1 and the interface 106-4 of the die 304-2 are selected to be in an inactive mode. However, the subject technology is not limited thereto. In some embodiments, when an advanced area (e.g., corresponding to an interface 106) is selected for an active mode, each standard area (e.g., corresponding to an interface 104) has dummy bumps, each advanced area in an inactive mode has dummy bumps, and each advanced area in an active mode has advanced bumps (e.g., micro bumps). In some embodiments, each advanced area has advanced bumps (e.g., micro bumps) regardless of whether they are active. In some embodiments, each standard area has standard bumps regardless of whether they are active. The electrical connection path between the dies 304 and the die 307 may include, among others, (a) the bumps in the advanced areas in an active mode (e.g., corresponding to the interface 106-2 for the die 304-1 and the interface 106-3 for the die 304-2) disposed at the bottom of the dies 304, (b) advanced package interconnects at or in the package substrate, and (c) the bumps in the areas of the interfaces 309 of the die 307 disposed at the bottom of the die 307.

Similar to the description provided with reference to Figure 2B, the multi-die package 303 of Figure 3B may have one or more dies 304 and one or more target dies (e.g., the die 307), and as the placement of the advanced and standard areas is symmetric (e.g., with respect to a line parallel to a y-axis and crossing a middle region of a die), various die connection configurations are possible.

As an example, if, for the die 304-1, (a) there are 50 common signals for both interfaces, 30 standard signals for the interface 104, and 10 advanced signals for the interface 106, (b) the interface 106-2 is in an active mode, and (c) the interface 106-1 is in an inactive mode, then the 50 common signals and the 30 standard signals are selectively directed to the interface 104-1 for the standard UCIe interface; and the 50 common signals and the 10 advanced signals are selectively directed to the interface 106-2 for the advanced UCIe interface.

Figure 4A illustrates a perspective view of a multi-die package 400 having semiconductor dies 406 with multiple different semiconductor interconnect interfaces connected to a die 404 in accordance with some embodiments. In some embodiments, the package 400 is an instance of one of the previous packages described above (e.g., the package 200, 203, 302, or 303).

Figure 4B illustrates a cross-sectional view of the multi-die package 400 shown in Figure 4A in accordance with some embodiments. The cross-sectional view in Figure 4B corresponds to the X-X' cross-section shown in Figure 4A. As shown in Figure 4B, the package 400 includes a substrate 402 with an interconnect 408 that connects the die 406-1 to the die 404. In some embodiments, the interconnect 408 is an imposer or bridge element. The interconnect 408 connects the die 406-1 via the interface 412 (e.g., an array of bumps) and connects the die 404 via the interface 410 (e.g., another array of bumps). In some embodiments the interfaces 410 and 412 have a same arrangement of bumps (e.g., same bump size and same pitch between bumps).

Figure 5A illustrates a cross-sectional view of a portion of an example interface (e.g., the interface 104 or the interface 106 in Figure 1) that is in an active mode in accordance with some embodiments. The cross-sectional view in Figure 5A is a bottom-up cross-sectional view of one bump and some of the underlying structure in an interface (e.g., the interface 104 or the interface 106 of the die 100). For example, the interface in the active mode may be the interface 104-1 or 104-2 in Figure 2A or the interface 106-1 in Figure 2B.

As shown in Figure 5A, a structure of the portion of the interface in the active mode may include a substrate 500 and one or more components 506 (e.g., transistors) disposed on the substrate 500. The structure further includes one or more traces 508 (e.g., conductive traces, such as metal traces, or conductive pads) electrically connected to the one or more components 506 and one or more vias 510 (e.g., conductive through interconnects) electrically connected to the one or more traces 508. In the example of Figure 5A, the traces 508 include a trace 508-1 connecting the component 506 to the via 510-1 in a dielectric layer 502-1, a trace 508-2 connecting the via 510-1 to the via 510-2 in a dielectric layer 502-2; and a trace 508-3 connecting the via 510-2 to the via 510-3 in a dielectric layer 502-3. The structure in Figure 500 further includes a contact pad 512 in a passivation layer 504 connected to the via 510-3, and a bump 514 (e.g., a standard bump or micro bump) on the passivation layer 504. For an interface in the active mode, as shown in Figure 5A, the bump 514 is connected to the contact pad 512 via an electrical connector 516. Figure 5A is a simplified schematic cross-section provided for convenience, and the subject technology is not limited thereto. In actual fabrication, the structure may have many other components or omit some of the components shown. In some embodiments, the structure of the interface includes more or less dielectric layers 502 and more or less corresponding traces 508 and vias 510. In some embodiments, the passivation layer 504 is composed of a dielectric material. In some embodiments, the passivation layer 504 is composed of a same material as the dielectric layers 502. In some embodiments, all of the dielectric layers 502 are composed of a same material.

The bump 514 shown in Figure 5A may be an advanced bump (e.g., a micro bump). Each interface 104 and 106 may include a plurality of bumps. Each of the bumps for a single interface may have similar or same physical and/or electrical characteristics. In some embodiments, the different interfaces have different bump sizes and/or orientations (e.g., bump pitches). In some embodiments, the different interfaces have the same bump sizes and/or orientations. The bump 514 shown in Figure 4A may be connected to a package substrate using a package interconnect (e.g., a silicon interposer or a silicon bridge) as shown in Figure 4B.

The bumps for an interface in an active mode may be configured for electrical and mechanical connection to one or more connections on the package substrate located outside of the die (e.g., the die 100), configured to electrically communicate with the one or more such connections, configured to electrically communicate with transistors in the digital core area of the die, and configured to electrically communicate with one or more components (e.g., transistors) in the interface. When a die (e.g., the die 100) comprises a transceiver, each bump for the interface in the active mode may be electrically connected to one or more components in the interface. For example, the bumps for the interface in an active mode may use transistors in the interface to transmit or receive signals (e.g., data or control signals).

In some embodiments, the bumps for a first type of interface (e.g., a standard interface) may the same as the bumps for a second type of interface (e.g., an advanced interface). In some embodiments, the bumps for a standard interface are standard bumps (e.g., a standard C4 bump or copper pillar) and the bumps for an advanced interface are advanced bumps (e.g., micro bumps). In some embodiments, the structure for a standard interface is less complex (e.g., less layers, less elements and/or larger) than the structure for an advanced interface (e.g., the standard interface supports less advanced and/or less complex signaling than the advanced interface). In some embodiments, a bump for a standard interface is connected to conductive traces on the package substrate (e.g., the package substrate shown in Figure 4B) without using an advanced package interconnect.

Thus, as described previously, the bumps in a standard area of a die (e.g., the die 100) in an active mode may be configured for electrical and mechanical connection to one or more standard connections on the package substrate located outside the die, configured to electrically communicate with the one or more standard connections, configured to electrically communicate with transistors in the digital core area of the die, and configured to electrically communicate with one or more transistors in the standard area. The bumps in an advanced area of a die (e.g., the die 100) in an active mode may be configured for electrical and mechanical connection to one or more advanced connections on the package substrate located outside the die, configured to electrically communicate with the one or more advanced connections, configured to electrically communicate with transistors in the digital core area of the die, and configured to electrically communicate with one or more transistors in the advanced area.

In some embodiments, a digital core area (e.g., the digital core 102) of the die also has a plurality of bumps. For example, a bump (and/or bump array) and its underlying structure in the digital core area may be similar to that of an interface (shown in Figure 5A). In some embodiments, the digital core area uses a same bump structure as a standard area of the die and/or an advanced area of the die. However, the underlying structure of the digital core area may be different (e.g., more complex) than the underlying structure of an interface. The bumps in the digital core area may be connected to conductive traces on the package substrate (e.g., the package substrate shown in Figure 4B), e.g., with or without using an advanced package interconnect. The bumps in the digital core area may be used to provide power, ground, control signals, and/or other signals to the digital core. In an example, the circuit components and interconnects in the digital core area may be more complex than those of an interface (e.g., the structure shown in Figure 5A).

Figure 5B illustrates a cross-sectional view of a portion of an example interface that is in an inactive mode in accordance with some embodiments. For example, the interface in the inactive mode may be the interface 106-1 in Figure 2A or the interfaces 104-1 and 104-2 in Figure 2B. The structure shown in Figure 5B is similar to that of Figure 5A, except that in Figure 5B, the bump 514 is a dummy bump that is not connected to the component(s) 506. In this example, the bump 514 is not connected to the contact pad 512 as there is no opening in the passivation layer 504 (e.g., the connector 516 is not present in Figure 5B). In some embodiments, one or more other components are not included in the structure for an inactive interface (e.g., the via 510-3 is not present and/or the trace 508-3 is not present). In an inactive mode, the component(s) 506 may be powered down, disabled, or placed into a low power state. In an inactive mode, the bumps 514 are fabricated as dummy bumps. These dummy bumps are not used to transmit or receive signals. Thus, dummy bumps are electrically inactive, but they may provide mechanical support (e.g., to mechanically attach a die (e.g., the die 100) to a package substrate). The dummy bumps in an inactive mode for an advanced area may not be required to be advanced bumps (e.g., micro bumps) as they do not carry signals. Hence, when a die (e.g., the die 100) is selected for a standard interface, during a final stage(s) of the fabrication process, standard dummy bumps (e.g., standard C4 bumps) instead of advanced bumps may be placed in an advanced area in an inactive mode. For example, to simplify the process, the same bumps (e.g., standard bumps) may be placed in all of the areas (e.g., the advanced area, the standard area, and the digital core area) when a standard interface is selected for the die. As an example in which the advanced area is inactive, the standard bumps in the standard area and the digital core area may be used to transmit and receive signals, but the standard bumps in the advanced area (that is in the inactive mode) are dummy bumps not used for transmission or reception of signals. Thus, in one or more aspects, dummy bumps are not electrically active and/or may be electrically insulated/isolated. There are a number of methods of fabricating dummy bumps and associated layers/elements so that the dummy bumps are inactive or electrically isolated. In one example, no openings are created in the passivation layer 504, as shown in Figure 5B, so that the bumps 514 are electrically isolated from their underlying components and electrically insulated/isolated from the digital core area. In another example, no final vias 510-3 are formed for the inactive interface so that the bumps 514 in the inactive interface are electrically insulated/isolated. In yet another example, at least a portion of one or more layers or elements may be removed or not removed. In yet another example, an additional one or more layers or elements may be added to electrically insulate/isolate the bumps 514 for the inactive interface.

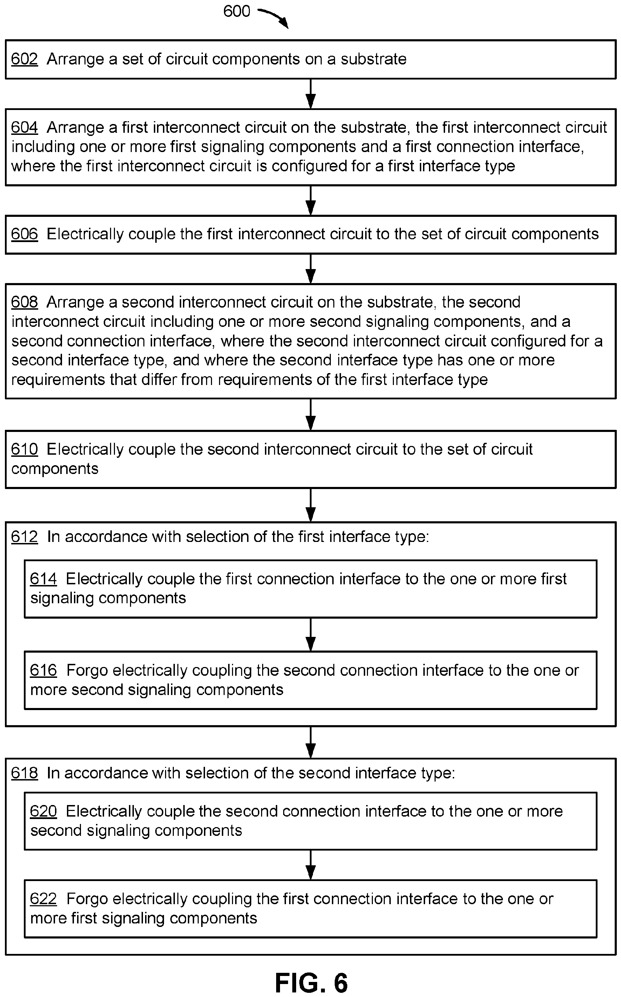

Figure 6 is a flow diagram illustrating a method 600 of fabricating a die in accordance with some embodiments. The method 600 may be performed using a system (e.g., a fabrication system, an assembly system, and/or a design system) having control circuitry and memory storing instructions for execution by the control circuitry. In some embodiments, the method 600 is performed by executing instructions stored in the memory of a computing system.

A set of circuit components are arranged (602) on a substrate. In some embodiments, the set of circuit components comprises a plurality of analog and/or digital components (e.g., transistors, logic gates, amplifiers, and the like). For example, the set of circuit components may comprise a digital core (e.g., the digital core 102).

A first interconnect circuit is arranged (604) on the substrate, the first interconnect circuit including one or more first signaling components (e.g., transistors) and a first connection interface (e.g., one or more bumps and/or pillars), where the first interconnect circuit is configured for a first interface type (e.g., a standard UCIe interface). For example, the first interconnect circuit may comprise the interfaces 104-1 and 104-2 in Figure 1.

The first interconnect circuit is electrically coupled (606) to the set of circuit components (e.g., via at least a subset of the lines 108). In some embodiments, the first interconnect circuit is electrically coupled to the set of circuit components using one or more traces, vias, and/or other interconnect components.

A second interconnect circuit is arranged (608) on the substrate, the second interconnect circuit comprising one or more second signaling components (e.g., transistors), and a second connection interface (e.g., one or more bumps and/or pillars), where the second interconnect circuit configured for a second interface type (e.g., an advanced UCIe interface), and where the second interface type has one or more requirements that differ from requirements of the first interface type. For example, the second interface type may require a shorter interconnect (e.g., trace) length and/or a smaller pitch size. As an example, the second interconnect circuit may comprise the interface 106 in Figure 1.

The second interconnect circuit is electrically coupled (610) to the set of circuit components (e.g., via at least a subset of the lines 108). In some embodiments, the second interconnect circuit is electrically coupled to the set of circuit components using one or more traces, vias, and/or other interconnect components.

In accordance with selection of the first interface type (612): the first connection interface is electrically coupled (614) to the one or more first signaling components (e.g., as illustrated in Figure 5A); and the second connection interface is not electrically coupled (616) to the one or more second signaling components (e.g., is electrically isolated as illustrated in Figure 5B). In some embodiments, the first connection interface is electrically coupled to the one or more first signaling components using one or more conductive vias and/or traces.

In accordance with selection of the second interface type (618): the second connection interface is electrically coupled (620) to the one or more second signaling components; and the first connection interface is not electrically coupled (622) to the one or more first signaling components. In some embodiments, the second connection interface is electrically coupled to the one or more second signaling components using one or more conductive vias and/or traces. In some embodiments, an arrangement of components (e.g., bumps and/or pillars) for the first and second connection interfaces is selected (from two or more options) based on which interconnect circuit is selected for use. In some embodiments, a mask layer for fabricating the first and second connection interfaces is selected based on which interconnect circuit is selected for use.

In some embodiments, electrically coupling the first connection interface to the one or more first signaling components comprises filling, with an electrically-conductive material, one or more holes in a passivation layer that physically separates the first connection interface from the one or more first signaling components. In some embodiments, electrically coupling the first connection interface to the one or more first signaling components comprises depositing and patterning an electrically-conductive layer to form one or more electrically-conductive paths between the first connection interface and the one or more first signaling components.

In some embodiments, the first connection interface is electrically connected to the one or more first signaling components via an electrically-conductive material (e.g., the connector 516). In some embodiments, electrically coupling the second connection interface to the one or more second signaling components comprises electrically connecting the second connection interface to the one or more second signaling components via a set of holes in a passivation layer (e.g., the passivation layer 504) that physically separates the second connection interface from the one or more second signaling components.

Although Figure 6 illustrates a number of logical stages in a particular order, stages which are not order dependent may be reordered and other stages may be combined or broken out. Some reordering or other groupings not specifically mentioned will be apparent to those of ordinary skill in the art, so the ordering and groupings presented herein are not exhaustive. Moreover, it should be recognized that the stages could be implemented in hardware, firmware, software, or any combination thereof.

In one or more examples, a reference numeral without a dash (e.g., 100; 104; 106; 304; 406; 502; 508; 510) may refer to one or more same reference numerals with a dash (e.g., 100-1, 100-2; 104-1, 104-2, 104-3, 104-4; 106-1, 106-2, 106-3, 106-4; 304-1, 304-2; 406-1, 406-2; 502-1, 502-2, 502-3; 508-1, 508-2, 508-3; 510-1, 510-2, 510-3). While the digital core 102 is not illustrated in Figures 2A to 4A for brevity, in one or more examples, the digital core 102 is included in each or some of dies 100-1, 100-2, 304-1, 304-2, 406-1, and 406-2 in Figures 2A to 4A. In one or more examples, a semiconductor die may represent any or some of die 100, 100-1, 100-2, 304-1, 304-2, 406-1, or 406-2. In one or more examples, bumps (e.g., standard bumps, advanced bumps, or a combination thereof) may be disposed substantially on the entire bottom surface of a semiconductor die described herein.

Turning now to some example embodiments. Various examples and aspects of the present disclosure are described below. These are provided as examples, and do not limit the scope of the present disclosure.

(A1) In one aspect, some embodiments include a semiconductor die (e.g., the die 100). The semiconductor die includes: (i) a substrate (e.g., the substrate 500, Figure 5A); (ii) a set of circuit components arranged on the substrate and having transistors (e.g., the digital core 102, Figure 1); (iii) a first interconnect circuit (e.g., the interfaces 104, Figure 1) arranged on the substrate, spaced apart from the set of circuit components along at least one of first and second directions, and electrically coupled to the set of circuit components, the first interconnect circuit configured for a first interface type (e.g., a standard UCIe type interface) and comprising: (a) one or more first signaling components having transistors (e.g., the component 506, Figure 5A); and (b) a first connection interface (e.g., the bump 514, Figure 5A) disposed on the one or more first signaling components and spaced apart from the one or more first signaling components along a third direction; and (iv) a second interconnect circuit (e.g., the interface 106, Figure 1) arranged on the substrate, spaced apart from the set of circuit components along at least one of the first and second directions, and electrically coupled to the set of circuit components, the second interconnect circuit configured for a second interface type (e.g., an advanced UCIe type interface), the second interface type having one or more requirements that differ from requirements of the first interface type, the second interconnect circuit comprising: (c) one or more second signaling components (e.g., the component 506, Figure 5A) having transistors; and (d) a second connection interface (e.g., the bump 514, Figure 5A) disposed on the one or more second signaling components and spaced apart from the one or more second signaling components along the third direction, wherein: (1) in accordance with selection of the first interface type, the first connection interface is electrically coupled to the one or more first signaling components, and the second connection interface is electrically isolated from the one or more second signaling components (e.g., the second connection interface comprises dummy bumps); and (2) in accordance with selection of the second interface type, the first connection interface is electrically isolated from the one or more first signaling components, and the second connection interface is electrically coupled to the one or more second signaling components. For example, the first interface type corresponds to a universal chiplet interconnect express (UCIe) advanced interface and the second interface type corresponds to UCIe standard interface. In some embodiments, the first and second signaling components are on a first set of one or more layers and the first and second connection interfaces are on a second layer (e.g., a topmost layer). In some embodiments, selection of the first interface type comprises coupling the semiconductor die to a second semiconductor die using an interconnect of the second semiconductor die that is configured for the first interface type.

(A2) In some embodiments of A1: (i) a physical structure of the first interconnect circuit in accordance with selection of the first interface type is different from a physical structure of the first interconnect circuit in accordance with selection of the second interface type; (ii) in accordance with selection of the first interface type, one or more first conductive paths disposed along the third direction electrically connect the first connection interface to the one or more first signaling components, and one or more dielectric materials disposed along the third direction cause the second connection interface to be electrically isolated from the one or more second signaling components without a continuous conductive path between the second connection interface and the one or more second signaling components; and (iii) in accordance with selection of the second interface type, one or more second conductive paths disposed along the third direction electrically connect the second connection interface to the one or more second signaling components, and one or more dielectric materials disposed along the third direction cause the first connection interface to be electrically isolated from the one or more first signaling components.

(A3) In some embodiments of A1 or A2, the one or more requirements comprise a pitch between components of the second connection interface, and the pitch required between the components of the second connection interface is different from a pitch required between components of the first connection interface.

(A4) In some embodiments of any of A1-A3: (i) the one or more first signaling components are configured to support a first pitch between components of the first connection interface; (ii) the one or more second signaling components are configured to support a second pitch between components of the second connection interface; (iii) the second pitch is different from the first pitch; (iv) in accordance with selection of the first interface type, the components of the first connection interface have the first pitch, and the components of the second connection interface have the first pitch instead of the second pitch; and (v) in accordance with selection of the second interface type, the components of the first connection interface have the second pitch instead of the first pitch, and the components of the second connection interface have the second pitch.

(A5) In some embodiments of any of A1-A4, the one or more requirements comprise a maximum trace length for an interconnect for being connected to the second interconnect circuit, and the maximum trace length for the interconnect for being connected to the second interconnect circuit is different from a maximum trace length for an interconnect for being connected to the first interconnect circuit. For example, a maximum trace length of 2mm for an advanced interface or a maximum trace length of 25mm for a standard interface.

(A6) In some embodiments of any of A1-A5: (i) in accordance with selection of the first interface type, the first and second connection interfaces have a first arrangement of components; and (ii) in accordance with selection of the second interface type, the first and second connection interfaces have a second arrangement of components, different than the first arrangement. For example, the components in the first and second arrangements may comprise bumps or pillars.

(A7) In some embodiments of any of A1-A6: (i) in accordance with selection of the first interface type, the first connection interface is electrically coupled to the one or more first signaling components using one or more conductive vias and one or more conductive traces; and (ii) in accordance with selection of the second interface type, the first connection interface is mechanically connected to the one or more first signaling components without the one or more conductive vias and the one or more conductive traces. In some embodiments, the second connection interface is electrically coupled to the one or more first signaling components using one or more vias and/or one or more traces.

(A8) In some embodiments of any of A1-A7, the first connection interface comprises a first plurality of bumps, and the second connection interface comprises a second plurality of bumps. For example, on die bump arrays connect multiple dies to a common substrate using flip-chip packaging technology.

(A9) In some embodiments of A8, the first plurality of bumps are arranged with a first pitch, and the second plurality of bumps are arranged with a second pitch, different from the first pitch. For example, first plurality of bumps are micro bumps having a fine pitch and the second plurality of bumps have a larger pitch.

(A10) In some embodiments of A8 or A9, the first plurality of bumps have a first size, and the second plurality of bumps have a second size, different from the first size.

(A11) In some embodiments of any of A1-A7, the first connection interface comprises a first plurality of electrically-conductive pillars, and the second connection interface comprises a second plurality of electrically-conductive pillars. For example, the electrically-conductive pillars may be composed of metal such as copper or gold.

(A12) In some embodiments of any of A1-A11: (i) the first interconnect circuit (e.g., the interfaces 104) is divided into a first portion (e.g., the interface 104-1) and a second portion (e.g., the interface 104-2); (ii) the first portion is arranged on a first side of the second interconnect circuit; (iii) a second portion is arranged on a second side of the second interconnect circuit, the second side opposite the first side; (iv) the second interconnect circuit and the first portion and the second portion of the first interconnect circuit are arranged along one of the first and second directions and along one side of the semiconductor die; and (v) the set of circuit is arranged along another side of the semiconductor die, the another side opposite to the one side. For example, a first half of the connections for the first interconnect circuit may be on one side of the second interconnect circuit and the other half of the connection may be on the opposite side. In some embodiments, the first interconnect circuit is divided into a first portion and a second portion, the first portion is arranged on a first side of the second interconnect circuit, and a second portion is arranged on a second side of the second interconnect circuit, the second side opposite the first side.

(A13) In some embodiments of any of A1-A12, the semiconductor die further comprising a third interconnect circuit arranged on the substrate and electrically coupled to the set of circuit components, the third interconnect circuit configured for the first interface type, where the third interconnect circuit is on a first side of the second interconnect circuit and the first interconnect circuit is on a second side of the second interconnect circuit. In some embodiments, in accordance with use of the first interconnect circuit, the third interconnect circuit is maintained in an inactive mode, and, in accordance with use of the third interconnect circuit, the first interconnect circuit is maintained in the inactive mode. In some embodiments, maintaining an interconnect circuit in an inactive mode comprises forgoing providing power (or providing reduced power) to the interconnect circuit. In some embodiments, maintaining an interconnect circuit in an inactive mode comprises not connecting (and/or disconnecting) portions of the interconnect circuit. In some embodiments, in accordance with use of the second interconnect circuit, the first and third interconnect circuits are maintained in the inactive mode.

(A14) In some embodiments of any of A1-A13, one of the first interconnect circuit and the second interconnect circuit is configured to have a power level that is greater than a power level of the other one of the first interconnect circuit and the second interconnect circuit.

(A15) In some embodiments of any of A1-A14: (i) in accordance with selection of the first interface type, the one or more first signaling components are configured to electrically and mechanically connect to a package interconnect located outside the semiconductor die, and the one or more second signaling components are configured to mechanically connect to the package interconnect and to be electrically isolated from the package interconnect; (ii) in accordance with selection of the second interface type, the one or more first signaling components are configured to mechanically connect to the package interconnect and to be electrically isolated from the package interconnect, and the one or more second signaling components are configured to electrically and mechanically connect to the package interconnect; and (iii) the one or more first signaling components and the one or more second signaling components are electrically and mechanically coupled to the set of circuit components regardless of selection of the first interface type or the second interface type. For example, the package interconnect may be an interposer or a bridge. In some embodiments, the first connection interface and the second connection interface are each configured to electrically and mechanically connect to the package interconnect.

(A16) In some embodiments of any of A1-A15: (i) the set of circuit components comprises a first plurality of transistors, (ii) the one or more first signaling components comprise one or more drivers that include a second plurality of transistors, (iii) the one or more second signal components comprise one or more other drivers that include a third plurality of transistors, and (iv) each of the first connection interface and the second connection interface comprises bumps or pillars without transistors. In some embodiments, the set of circuit components comprises one or more digital logic components, one or more analog components, and/or one or more timing components. In some embodiments, the one or more second signaling components comprises one or more drivers and/or one or more switches.

(B1) In another aspect, some embodiments include a multi-die package (e.g., the package 200, 203, 302, or 303) that includes: (i) the semiconductor die of A1 (e.g., the die 100); and (ii) a second semiconductor die (e.g., the die 201, 202, 306, or 307) electrically coupled to the semiconductor die of A1 via one of the first interconnect circuit and the second interconnect circuit, where the second semiconductor die comprises an interconnect configured for an interface type that is same as an interface type of the one of the first interconnect circuit and the second interconnect circuit. In some embodiments, the semiconductor die of A1 is coupled to only a portion of a connection interface of the second semiconductor die. In some embodiments, a third semiconductor die is coupled to a different portion of the connection interface of the second semiconductor die.

(C1) In another aspect, some embodiments include a semiconductor die (e.g., the die 100), comprising: (i) a set of circuit components (e.g., the digital core 102) having transistors and arranged on a substrate (e.g., the substrate 500); (ii) a first interconnect circuit (e.g., the interfaces 104) having transistors, arranged on the substrate, and configured for a first interface type to connect to a first semiconductor die; and (iii) a second interconnect circuit (e.g., the interface 106) having transistors, arranged on the substrate, and configured for a second interface type to connect to a second semiconductor die, where: (a) an interface layer of the first interconnect circuit has a first arrangement of components in accordance with selection of the first interface type; (b) the interface layer of the first interconnect circuit has a second arrangement of components in accordance with selection of the second interface type; and (c) the second arrangement is different from the first arrangement.

(C2) In some embodiments of C1, the semiconductor die includes the features of any of A1-A16 above.

(D1) In another aspect, some embodiments include a method (e.g., the method 600) of fabricating a semiconductor die (e.g., the die 100). In some embodiments, the method is performed at a system having memory and control circuitry. The method includes: (i) arranging a set of circuit components on a substrate; (ii) arranging a first interconnect circuit on the substrate, the first interconnect circuit comprising one or more first signaling components and a first connection interface, wherein the first interconnect circuit is configured for a first interface type; (iii) electrically coupling the first interconnect circuit to the set of circuit components; (iv) arranging a second interconnect circuit on the substrate, the second interconnect circuit comprising one or more second signaling components, and a second connection interface, wherein the second interconnect circuit configured for a second interface type, and wherein the second interface type has one or more requirements that differ from requirements of the first interface type; (v) electrically coupling the second interconnect circuit to the set of circuit components; (vi) in accordance with selection of the first interface type: (a) electrically coupling the first connection interface to the one or more first signaling components; and (b) not electrically coupling the second connection interface to the one or more second signaling components; and (vii) in accordance with selection of the second interface type: (1) electrically coupling the second connection interface to the one or more second signaling components; and (2) not electrically coupling the first connection interface to the one or more first signaling components. In some embodiments, an arrangement of components (e.g., bumps and/or pillars) for the first and second connection interfaces is selected (from two or more options) based on which interconnect circuit is selected for use. In some embodiments, a mask layer for fabricating the first and second connection interfaces is selected based on which interconnect circuit is selected for use.

(D2) In some embodiments of D1, electrically coupling the first connection interface to the one or more first signaling components comprises: (i) filling, with an electrically-conductive material, one or more holes in a passivation layer that physically separates the first connection interface from the one or more first signaling components; or (ii) depositing and patterning an electrically-conductive layer to form one or more electrically-conductive paths between the first connection interface and the one or more first signaling components. In some embodiments, the first connection interface is electrically connected to the one or more first signaling components via an electrically-conductive material. In some embodiments, electrically coupling the second connection interface to the one or more second signaling components comprises electrically connecting the second connection interface to the one or more second signaling components via a set of holes in a passivation layer that physically separates the second connection interface from the one or more second signaling components.

(D3) In some embodiments of D1 or D2, the first and second connection interfaces comprise arrays of bumps (or pillars). In some embodiments, the arrays of bumps are fabricated using a top layer mask. For example, the top layer mask determines whether the arrays of bumps comprise micro bumps or standard bumps and determines a bump pitch for the arrays of bumps. In some embodiments, a subset of the bumps are dummy bumps.

In one or more examples, when an element is electrically coupled, electrically connected or the like to a different element, a conductive path exists between the element and the different element. In an example, such a conductive path is not blocked or interrupted. In an example, the entire conductive path is continuous and exists from the element and up to the different element. In an example, such a conductive path is electrically conductive. In an example, the conductive path may be formed of an electrically-conductive material (e.g., metal). In an example, when no power is supplied between the two elements, there is no current (or only a leakage current) flowing between the two elements, and when power is supplied between the two elements (e.g., different voltages are applied to the two elements), a current may flow between the two elements.

In one or more examples, when an element is electrically isolated from (or not electrically coupled or connected to) a different element, a dielectric material may exist between the element and the different element. In an example, when power is supplied between the two elements, no current (or only a leakage current) flows between the two elements because the dielectric material prevents the flow of the current. A conductive path between the two elements may be blocked by such a dielectric material.

Some or many of the steps of fabricating the semiconductor die may occur concurrently. For example, many (or most) of the steps needed to fabricate the set of circuit, the first interconnect circuit, and the second interconnect circuit may occur simultaneously as they may share the same dielectric layers and conductive layers that are patterned differently. For example, the transistors in the set of circuit, the first interconnect circuit, and the second interconnect circuit may be fabricated at the same time. With reference to Figures 5A and 5B, as an example, some or all layers (and some or all bumps) of the set of circuits, the first interconnect circuit, and the second interconnect circuit may be fabricated simultaneously.

While the subject technology is described with one or more examples (e.g., a specific number of dies, a specific number of modules, a specific number of areas, a specific number of channels), these are examples, and the subject technology is not limited thereto.

In one or more implementations, not all of the depicted components in each figure may be required, and one or more implementations may include additional components not shown in a figure. Variations in the arrangement and type of the components may be made without departing from the scope of the subject disclosure. Additional components, different components, or fewer components may be utilized within the scope of the subject disclosure. Headings and subheadings, if any, are used for convenience only and do not limit the invention. The word "exemplary" is used to mean serving as an example or illustration. Any implementation described herein as an "example" is not necessarily to be construed as preferred or advantageous over other implementations. Relational terms such as first and second and the like may be used simply for ease of understanding without necessarily requiring or implying any actual relationship or order between elements or actions and without necessarily requiring or implying that they have different characteristics unless stated otherwise.

Phrases such as an aspect, the aspect, another aspect, some aspects, one or more aspects, an implementation, the implementation, another implementation, some implementations, one or more implementations, an embodiment, the embodiment, another embodiment, some embodiments, one or more embodiments, a configuration, the configuration, another configuration, some configurations, one or more configurations, the subject technology, the disclosure, the present disclosure, other variations thereof and alike are for convenience and do not imply that a disclosure relating to such phrase(s) is essential to the subject technology or that such disclosure applies to all configurations of the subject technology. A disclosure relating to such phrase(s) may apply to all configurations, or one or more configurations. A disclosure relating to such phrase(s) may provide one or more examples. A phrase such as an aspect or some aspects may refer to one or more aspects and vice versa, and this applies similarly to other foregoing phrases.

A phrase "at least one of" preceding a series of items, with the terms "and" or "or" to separate any of the items, modifies the list as a whole, rather than each member of the list. The phrase "at least one of" does not require selection of at least one item; rather, the phrase allows a meaning that includes at least one of any one of the items, and/or at least one of any combination of the items, and/or at least one of each of the items. By way of example, each of the phrases "at least one of A, B, and C" and "at least one of A, B, or C" may refer to only A, only B, or only C; any combination of A, B, and C; and/or at least one of each of A, B, and C.

Further, at least one of a plurality of elements can represent (i) one element of the plurality of elements, (ii) some elements of the plurality of elements, or (iii) all elements of the plurality of elements. Further, "at least some," "some," "some elements," "a portion," "portions," "at least a portion," "at least portions," "a part," "at least a part," "parts," "at least parts," "one or more," or the like of the plurality of elements can represent (i) one element of the plurality of elements, (ii) a part of the plurality of elements, (iii) parts of the plurality of elements, (iv) multiple elements of the plurality of elements, or (v) all of the plurality of elements. Moreover, "at least some portions," "some," "at least some parts," "a portion," "portions," "at least a portion," "at least portions," "a part," "at least a part," "parts," "at least parts," or the like of an element can represent (i) a portion (or a part) of the element, (ii) one or more portions (or parts) of the element, or (iii) the element, or all portions of the element.

The expression of a first element, a second elements "and/or" a third element should be understood as one of the first, second and third elements or as any or all combinations of the first, second and third elements. By way of example, A, B and/or C can refer to only A; only B; only C; any or some combination of A, B, and C; or all of A, B, and C. Furthermore, an expression "element A/element B" may be understood as element A and/or element B.

In one or more aspects, the terms "between" and "among" may be used interchangeably simply for convenience unless stated otherwise. For example, an expression "between a plurality of elements" may be understood as among a plurality of elements. In another example, an expression "among a plurality of elements" may be understood as between a plurality of elements. In one or more examples, the number of elements may be two. In one or more examples, the number of elements may be more than two.

In one or more aspects, the terms "each other" and "one another" may be used interchangeably simply for convenience unless stated otherwise. For example, an expression "different from each other" may be understood as being different from one another. In another example, an expression "different from one another" may be understood as being different from each other. In one or more examples, the number of elements involved in the foregoing expression may be two. In one or more examples, the number of elements involved in the foregoing expression may be more than two.

Features of various embodiments of the present disclosure may be partially or wholly coupled to or combined with each other and may be variously inter-operated, linked or driven together. The embodiments of the present disclosure may be carried out independently from each other or may be carried out together in a co-dependent or related relationship. In one or more aspects, the components of each apparatus according to various embodiments of the present disclosure are operatively coupled and configured.

Unless otherwise defined, the terms (including technical and scientific terms) used herein have the same meaning as commonly understood by one of ordinary skill in the art to which example embodiments belong. It is further understood that terms, such as those defined in commonly used dictionaries, should be interpreted as having a meaning that is, for example, consistent with their meaning in the context of the relevant art and should not be interpreted in an idealized or overly formal sense unless expressly defined otherwise herein.

In one aspect, the blocks or components described in this present disclosure may be implemented in circuits or integrated circuits. A circuit or an integrated circuit may include one or more transistors.

In one or more aspects, a transistor may include one or more bipolar junction transistors (BJTs), which may refer to any of a variety of multi-terminal transistors operating on the principal of carrying current using both electrons and holes, including, but not limited to, an n-p-n BJT (NPN BJT) and a p-n-p BJT (PNP BJT).

In one or more aspects, transistors may include one or more field effect transistors (FETs), which may refer to any of a variety of multi-terminal transistors operating on the principals of controlling an electric field to control the shape and hence the conductivity of a channel of one type of charge carrier in a semiconductor material, including, but not limited to, a metal oxide semiconductor field effect transistor (MOSFET), a junction FET (JFET), a metal semiconductor FET (MESFET), a high electron mobility transistor (HEMT), a modulation doped FET (MODFET), an insulated gate bipolar transistor (IGBT), a fast reverse epitaxial diode FET (FREDFET), and an ion-sensitive FET (ISFET). A MOSFET may be an n-type MOSFET (NMOS) or a p-type MOSFET (PMOS). A complementary metal-oxide semiconductor (CMOS) device may include an NMOS and a PMOS.

In one or more aspects, transistors may include one or more BJTs and FETs. In one or more examples, transistors may include one or more BJTs and one or more CMOS devices, which may be referred to as Bi-CMOS devices.

Unless otherwise mentioned, various configurations described in the present disclosure may be implemented on a silicon, silicon-germanium (SiGe), gallium arsenide (GaAs), indium phosphide (InP) or indium gallium phosphide (InGaP) substrate, or any other suitable substrate. In one aspect, the terms base, emitter, and collector may refer to three terminals of a transistor and may refer to a base, an emitter and a collector of a bipolar junction transistor or may refer to a gate, a source, and a drain of a field effect transistor, respectively, and vice versa. In another aspect, the terms gate, source, and drain may refer to base, emitter, and collector of a transistor, respectively, and vice versa. In some aspects, a source and a drain may be used interchangeably. In describing a positional relationship, where the positional relationship between two parts is described, for example, using "on," "over," "under," "above," "below," "beneath," "near," "close to," or "adjacent to," "beside," "next to," or the like, one or more other parts may be located between the two parts unless a more limiting term, such as "immediate(ly)," "direct(ly)," or "close(ly)," is used. For example, when a structure is described as being positioned "on," "over," "under," "above," "below," "beneath," "near," "close to," or "adjacent to," "beside," or "next to" another structure, this description should be construed as including a case in which the structures contact each other as well as a case in which one or more additional structures are disposed or interposed therebetween. Furthermore, the terms "front," "rear," "back," "left," "right," "top," "bottom," "downward," "upward," "upper," "lower," "up," "down," "column," "row," "vertical," "horizontal," and the like refer to an arbitrary frame of reference.

It is understood that the specific order or hierarchy of steps, operations, or processes disclosed is an illustration of example approaches. Unless explicitly stated otherwise, it is understood that the specific order or hierarchy of steps, operations, or processes may be performed in different order, with the exception of steps and/or operations necessarily occurring in a particular order. Some of the steps, operations, or processes may be performed simultaneously. The accompanying method claims, if any, present elements of the various steps, operations or processes in a sample order, and are not meant to be limited to the specific order or hierarchy presented. These may be performed in serial, linearly, in parallel or in different order. It should be understood that the described instructions, operations, and systems can generally be integrated together in a single software/hardware product or packaged into multiple software/hardware products.

In describing a temporal relationship, when the temporal order is described as, for example, "after," "subsequent," "next," "before," "preceding," "prior to," or the like, a case that is not consecutive or not sequential may be included unless a more limiting term, such as "just," "immediate(ly)," or "direct(ly)," is used.

It is understood that, although the term "first," "second," or the like may be used herein to describe various elements, these elements should not be limited by these terms. These terms are only used to distinguish one element from another. For example, a first element could be a second element, and, similarly, a second element could be a first element, without departing from the scope of the present disclosure. Furthermore, the first element, the second element, and the like may be arbitrarily named according to the convenience of those skilled in the art without departing from the scope of the present disclosure.

In describing elements of the present disclosure, the terms "first," "second," "A," "B," "(a)," "(b)," or the like may be used. These terms are intended to identify the corresponding element(s) from the other element(s), and these are not used to define the essence, basis, order, or number of the elements.

A phrase "substantially the same" or "nearly the same" may indicate a degree of being considered as being equivalent to each other taking into account minute differences due to errors in the manufacturing process.

The expression that an element (e.g., layer, film, component, lens, electrode, filter, section, member, part, region, area, portion, or the like) "is engaged" with another element may be understood, for example, as that the element may be either directly or indirectly engaged with the another element. The term "is engaged" or similar expressions may refer to a term such as "covers," "surrounds," "is in contact," "overlaps," "crosses," "intersects," "is connected," "is coupled," "is attached," "is adhered," "is combined," "is linked," "is provided," "is disposed," "interacts," or the like. The engagement may involve one or more intervening elements disposed or interposed between the element and the another element, unless otherwise specified. Further, the element may be engaged at least partially or entirely with the another element, unless otherwise specified. Further, the element may be included in at least one of two or more elements that are engaged with each other. Similarly, the another element may be included in at least one of two or more elements that are engaged with each other. When the element is engaged with the another element, at least a portion of the element may be engaged with at least a portion of the another element. The term "with another element" or similar expressions may be understood as "another element," or "with, to, in, or on another element," as appropriate by the context. Similarly, the term "with each other" may be understood as "each other," or "with, to, or on each other," as appropriate by the context.

The phrase "through" may be understood, for example, to be at least partially through or entirely through.

The disclosure is provided to enable any person skilled in the art to practice the various aspects described herein. In some instances, when a detailed description of well-known functions or configurations may unnecessarily obscure aspects of the present disclosure, the detailed description thereof may be omitted. The disclosure provides various examples of the subject technology, and the subject technology is not limited to these examples. Various modifications to these aspects will be readily apparent to those skilled in the art, and the principles described herein may be applied to other aspects.

Unless stated otherwise, like reference numerals may refer to like elements throughout even when they are shown in different drawings. In one or more aspects, identical elements (or elements with identical names) in different drawings may have the same or substantially the same functions and properties unless stated otherwise. Names of the respective elements used in the following explanations are selected only for convenience and may be thus different from those used in actual products.

The shapes, sizes, areas, ratios, numbers, and the like disclosed in the drawings for describing implementations of the present disclosure are merely examples, and thus, the present disclosure is not limited to the illustrated details.

When the term "comprise," "have," "include," "contain," "constitute," or the like is used, one or more other elements may be added unless a term such as "only" or the like is used. The terms used in the present disclosure are merely used in order to describe particular embodiments, and are not intended to limit the scope of the present disclosure. The terms used herein are merely used in order to describe example embodiments, and are not intended to limit the scope of the present disclosure. The terms of a singular form may include plural forms unless the context clearly indicates otherwise. An element proceeded by "a," "an," "the," or "said" does not, without further constraints, preclude the existence of additional elements.

The terms such as a "line" or "direction" should not be interpreted only based on a geometrical relationship in which the respective lines or directions are parallel or perpendicular to each other, and may be meant as lines or directions having wider directivities within the range within which the components of the present disclosure can operate functionally.

In one or more aspects, an element, feature, or corresponding information (e.g., a level, range, dimension, size, or the like) is construed as including an error or tolerance range even where no explicit description of such an error or tolerance range is provided. An error or tolerance range may be caused by various factors (e.g., process factors, internal or external impact, or the like). Furthermore, while the subject disclosure may provide many example ranges and values, these are non-limiting examples, and other ranges and values are within the scope of the subject technology.

All structural and functional equivalents to the elements of the various aspects described throughout the disclosure that are known or later come to be known to those of ordinary skill in the art are expressly incorporated herein by reference and are intended to be encompassed by the claims. Moreover, nothing disclosed herein is intended to be dedicated to the public regardless of whether such disclosure is explicitly recited in the claims. No claim element is to be construed under the provisions of 35 U.S.C. §112, sixth paragraph, unless the element is expressly recited using the phrase "means for" or, in the case of a method claim, the element is recited using the phrase "step for."

The title, background, brief description of the drawings, abstract, and drawings are hereby incorporated into the disclosure and are provided as illustrative examples of the disclosure, not as restrictive descriptions. It is submitted with the understanding that they will not be used to limit the scope or meaning of the claims. In addition, in the detailed description, it can be seen that the description provides illustrative examples, and the various features are grouped together in various implementations for the purpose of streamlining the disclosure. The method of disclosure is not to be interpreted as reflecting an intention that the claimed subject matter requires more features than are expressly recited in each claim. Rather, as the claims reflect, inventive subject matter lies in less than all features of a single disclosed configuration or operation. The claims are hereby incorporated into the detailed description, with each claim standing on its own as a separately claimed subject matter.

The claims are not intended to be limited to the aspects described herein, but are to be accorded the full scope consistent with the language claims and to encompass all legal equivalents. Notwithstanding, none of the claims are intended to embrace subject matter that fails to satisfy the requirements of the applicable patent law, nor should they be interpreted in such a way.

The foregoing description, for purposes of explanation, has been described with reference to specific embodiments. However, the illustrative discussions above are not intended to be exhaustive or limit the claims to the precise forms disclosed. Many modifications and variations are possible in view of the above teachings. The embodiments were chosen and described in order to best explain principles of operation and practical applications, to thereby enable others skilled in the art.

Further embodiments of the invention are described in the following in the form of clauses.
1. A semiconductor die, comprising:
   a substrate;
   a set of circuit components arranged on the substrate and having transistors;
   a first interconnect circuit arranged on the substrate, spaced apart from the set of circuit components along at least one of first and second directions, and electrically coupled to the set of circuit components, the first interconnect circuit configured for a first interface type and comprising:
      one or more first signaling components having transistors; and
      a first connection interface disposed on the one or more first signaling components and spaced apart from the one or more first signaling components along a third direction; and
   a second interconnect circuit arranged on the substrate, spaced apart from the set of circuit components along at least one of the first and second directions, and electrically coupled to the set of circuit components, the second interconnect circuit configured for a second interface type, the second interface type having one or more requirements that differ from requirements of the first interface type, the second interconnect circuit comprising:
      one or more second signaling components having transistors; and
      a second connection interface disposed on the one or more second signaling components and spaced apart from the one or more second signaling components along the third direction,
   wherein:
      in accordance with selection of the first interface type, the first connection interface is electrically coupled to the one or more first signaling components, and the second connection interface is electrically isolated from the one or more second signaling components; and
      in accordance with selection of the second interface type, the first connection interface is electrically isolated from the one or more first signaling components, and the second connection interface is electrically coupled to the one or more second signaling components.
2. The semiconductor die of clause 1, wherein:
   a physical structure of the first interconnect circuit in accordance with selection of the first interface type is different from a physical structure of the first interconnect circuit in accordance with selection of the second interface type;
   in accordance with selection of the first interface type, one or more first conductive paths disposed along the third direction electrically connect the first connection interface to the one or more first signaling components, and one or more dielectric materials disposed along the third direction cause the second connection interface to be electrically isolated from the one or more second signaling components without a continuous conductive path between the second connection interface and the one or more second signaling components; and
   in accordance with selection of the second interface type, one or more second conductive paths disposed along the third direction electrically connect the second connection interface to the one or more second signaling components, and one or more dielectric materials disposed along the third direction cause the first connection interface to be electrically isolated from the one or more first signaling components.
3. The semiconductor die of one of the previous clauses, wherein the one or more requirements comprise a pitch between components of the second connection interface, and
   wherein the pitch required between the components of the second connection interface is different from a pitch required between components of the first connection interface.
4. The semiconductor die of one of the previous clauses, wherein:
   the one or more first signaling components are configured to support a first pitch between components of the first connection interface;
   the one or more second signaling components are configured to support a second pitch between components of the second connection interface;
   the second pitch is different from the first pitch;
   in accordance with selection of the first interface type, the components of the first connection interface have the first pitch, and the components of the second connection interface have the first pitch instead of the second pitch; and
   in accordance with selection of the second interface type, the components of the first connection interface have the second pitch instead of the first pitch, and the components of the second connection interface have the second pitch.
5. The semiconductor die of one of the previous clauses, wherein the one or more requirements comprise a maximum trace length for an interconnect for being connected to the second interconnect circuit, and
   wherein the maximum trace length for the interconnect for being connected to the second interconnect circuit is different from a maximum trace length for an interconnect for being connected to the first interconnect circuit.
6. The semiconductor die of one of the previous clauses, wherein:
   in accordance with selection of the first interface type, the first and second connection interfaces have a first arrangement of components; and
   in accordance with selection of the second interface type, the first and second connection interfaces have a second arrangement of components, different than the first arrangement.
7. The semiconductor die of one of the previous clauses, wherein:
   in accordance with selection of the first interface type, the first connection interface is electrically coupled to the one or more first signaling components using one or more conductive vias and one or more conductive traces; and
   in accordance with selection of the second interface type, the first connection interface is mechanically connected to the one or more first signaling components without the one or more conductive vias and the one or more conductive traces.
8. The semiconductor die of one of the previous clauses, wherein the first connection interface comprises a first plurality of bumps, and the second connection interface comprises a second plurality of bumps.
9. The semiconductor die of clause 8, wherein the first plurality of bumps are arranged with a first pitch, and the second plurality of bumps are arranged with a second pitch, different from the first pitch.
10. The semiconductor die of one of clauses 8 or 9, wherein the first plurality of bumps have a first size, and the second plurality of bumps have a second size, different from the first size.
11. The semiconductor die of one of the previous clauses, wherein the first connection interface comprises a first plurality of electrically-conductive pillars, and the second connection interface comprises a second plurality of electrically-conductive pillars.
12. The semiconductor die of one of the previous clauses, wherein:
   the first interconnect circuit is divided into a first portion and a second portion;
   the first portion is arranged on a first side of the second interconnect circuit;
   a second portion is arranged on a second side of the second interconnect circuit, the second side opposite the first side;
   the second interconnect circuit and the first portion and the second portion of the first interconnect circuit are arranged along one of the first and second directions and along one side of the semiconductor die; and
   the set of circuit is arranged along a different side of the semiconductor die, the different side opposite to the one side.
13. The semiconductor die of one of the previous clauses, further comprising a third interconnect circuit arranged on the substrate and electrically coupled to the set of circuit components, the third interconnect circuit configured for the first interface type,
   wherein the third interconnect circuit is on a first side of the second interconnect circuit and the first interconnect circuit is on a second side of the second interconnect circuit.
14. The semiconductor die of one of the previous clauses, wherein:
   one of the first interconnect circuit and the second interconnect circuit is configured to have a power level that is greater than a power level of the other one of the first interconnect circuit and the second interconnect circuit.
15. The semiconductor die of one of the previous clauses, wherein:
   in accordance with selection of the first interface type, the one or more first signaling components are configured to electrically and mechanically connect to a package interconnect located outside the semiconductor die, and the one or more second signaling components are configured to mechanically connect to the package interconnect and to be electrically isolated from the package interconnect;
   in accordance with selection of the second interface type, the one or more first signaling components are configured to mechanically connect to the package interconnect and to be electrically isolated from the package interconnect, and the one or more second signaling components are configured to electrically and mechanically connect to the package interconnect; and
   the one or more first signaling components and the one or more second signaling components are electrically and mechanically coupled to the set of circuit components regardless of selection of the first interface type or the second interface type.
16. The semiconductor die of one of the previous clauses, wherein:
   the set of circuit components comprises a first plurality of transistors,
   the one or more first signaling components comprise one or more drivers that include a second plurality of transistors,
   the one or more second signal components comprise one or more other drivers that include a third plurality of transistors, and
   each of the first connection interface and the second connection interface comprises bumps or pillars without transistors.
17. A multi-die package, comprising:
   the semiconductor die of one of the previous clauses; and
   a second semiconductor die electrically coupled to the semiconductor die via one of the first interconnect circuit and the second interconnect circuit,
   wherein the second semiconductor die comprises an interconnect configured for an interface type that is same as an interface type of the one of the first interconnect circuit and the second interconnect circuit.
18. A method of fabricating a semiconductor die, comprising:
   arranging a set of circuit components on a substrate;
   arranging a first interconnect circuit on the substrate, the first interconnect circuit comprising one or more first signaling components and a first connection interface, wherein the first interconnect circuit is configured for a first interface type;
   electrically coupling the first interconnect circuit to the set of circuit components;
   arranging a second interconnect circuit on the substrate, the second interconnect circuit comprising one or more second signaling components, and a second connection interface, wherein the second interconnect circuit configured for a second interface type, and wherein the second interface type has one or more requirements that differ from requirements of the first interface type;
   electrically coupling the second interconnect circuit to the set of circuit components;
   in accordance with selection of the first interface type:
      electrically coupling the first connection interface to the one or more first signaling components; and
      forgoing electrically coupling the second connection interface to the one or more second signaling components; and
   in accordance with selection of the second interface type:
      electrically coupling the second connection interface to the one or more second signaling components; and
      forgoing electrically coupling the first connection interface to the one or more first signaling components.
19. The method of clause 18, wherein electrically coupling the first connection interface to the one or more first signaling components comprises:
   filling, with an electrically-conductive material, one or more holes in a passivation layer that physically separates the first connection interface from the one or more first signaling components; or
   depositing and patterning an electrically-conductive layer to form one or more electrically-conductive paths between the first connection interface and the one or more first signaling components.
20. A semiconductor die, comprising:
   a set of circuit components having transistors and arranged on a substrate;
   a first interconnect circuit having transistors, arranged on the substrate, and configured for a first interface type to connect to a first semiconductor die; and
   a second interconnect circuit having transistors, arranged on the substrate, and configured for a second interface type to connect to a second semiconductor die,
   wherein:
      an interface layer of the first interconnect circuit has a first arrangement of components in accordance with selection of the first interface type;
      the interface layer of the first interconnect circuit has a second arrangement of components in accordance with selection of the second interface type; and
   the second arrangement is different from the first arrangement.

## Claims

1. A semiconductor die, comprising:
a substrate;
a set of circuit components arranged on the substrate and having transistors;
a first interconnect circuit arranged on the substrate, spaced apart from the set of circuit components along at least one of first and second directions, and electrically coupled to the set of circuit components, the first interconnect circuit configured for a first interface type and comprising:
one or more first signaling components having transistors; and
a first connection interface disposed on the one or more first signaling components and spaced apart from the one or more first signaling components along a third direction; and
a second interconnect circuit arranged on the substrate, spaced apart from the set of circuit components along at least one of the first and second directions, and electrically coupled to the set of circuit components, the second interconnect circuit configured for a second interface type, the second interface type having one or more requirements that differ from requirements of the first interface type, the second interconnect circuit comprising:
one or more second signaling components having transistors; and
a second connection interface disposed on the one or more second signaling components and spaced apart from the one or more second signaling components along the third direction,
wherein:
in accordance with selection of the first interface type, the first connection interface is electrically coupled to the one or more first signaling components, and the second connection interface is electrically isolated from the one or more second signaling components; and
in accordance with selection of the second interface type, the first connection interface is electrically isolated from the one or more first signaling components, and the second connection interface is electrically coupled to the one or more second signaling components.

2. The semiconductor die of claim 1, wherein:
a physical structure of the first interconnect circuit in accordance with selection of the first interface type is different from a physical structure of the first interconnect circuit in accordance with selection of the second interface type;
in accordance with selection of the first interface type, one or more first conductive paths disposed along the third direction electrically connect the first connection interface to the one or more first signaling components, and one or more dielectric materials disposed along the third direction cause the second connection interface to be electrically isolated from the one or more second signaling components without a continuous conductive path between the second connection interface and the one or more second signaling components; and
in accordance with selection of the second interface type, one or more second conductive paths disposed along the third direction electrically connect the second connection interface to the one or more second signaling components, and one or more dielectric materials disposed along the third direction cause the first connection interface to be electrically isolated from the one or more first signaling components.

3. The semiconductor die of one of the previous claims, wherein the one or more requirements comprise a pitch between components of the second connection interface, and
wherein the pitch required between the components of the second connection interface is different from a pitch required between components of the first connection interface.

4. The semiconductor die of one of the previous claims, wherein:
the one or more first signaling components are configured to support a first pitch between components of the first connection interface;
the one or more second signaling components are configured to support a second pitch between components of the second connection interface;
the second pitch is different from the first pitch;
in accordance with selection of the first interface type, the components of the first connection interface have the first pitch, and the components of the second connection interface have the first pitch instead of the second pitch; and
in accordance with selection of the second interface type, the components of the first connection interface have the second pitch instead of the first pitch, and the components of the second connection interface have the second pitch.

5. The semiconductor die of one of the previous claims, wherein the one or more requirements comprise a maximum trace length for an interconnect for being connected to the second interconnect circuit, and
wherein the maximum trace length for the interconnect for being connected to the second interconnect circuit is different from a maximum trace length for an interconnect for being connected to the first interconnect circuit.

6. The semiconductor die of one of the previous claims, wherein:
in accordance with selection of the first interface type, the first and second connection interfaces have a first arrangement of components; and
in accordance with selection of the second interface type, the first and second connection interfaces have a second arrangement of components, different than the first arrangement.

7. The semiconductor die of one of the previous claims, wherein:
in accordance with selection of the first interface type, the first connection interface is electrically coupled to the one or more first signaling components using one or more conductive vias and one or more conductive traces; and
in accordance with selection of the second interface type, the first connection interface is mechanically connected to the one or more first signaling components without the one or more conductive vias and the one or more conductive traces.

8. The semiconductor die of one of the previous claims, wherein the first connection interface comprises a first plurality of bumps, and the second connection interface comprises a second plurality of bumps.

9. The semiconductor die of claim 8, wherein the first plurality of bumps are arranged with a first pitch, and the second plurality of bumps are arranged with a second pitch, different from the first pitch.

10. The semiconductor die of one of claims 8 or 9, wherein the first plurality of bumps have a first size, and the second plurality of bumps have a second size, different from the first size.

11. The semiconductor die of one of the previous claims, wherein the first connection interface comprises a first plurality of electrically-conductive pillars, and the second connection interface comprises a second plurality of electrically-conductive pillars.

12. The semiconductor die of one of the previous claims, wherein:
the first interconnect circuit is divided into a first portion and a second portion;
the first portion is arranged on a first side of the second interconnect circuit;
a second portion is arranged on a second side of the second interconnect circuit, the second side opposite the first side;
the second interconnect circuit and the first portion and the second portion of the first interconnect circuit are arranged along one of the first and second directions and along one side of the semiconductor die; and
the set of circuit is arranged along a different side of the semiconductor die, the different side opposite to the one side.

13. The semiconductor die of one of the previous claims, further comprising a third interconnect circuit arranged on the substrate and electrically coupled to the set of circuit components, the third interconnect circuit configured for the first interface type,
wherein the third interconnect circuit is on a first side of the second interconnect circuit and the first interconnect circuit is on a second side of the second interconnect circuit.

14. The semiconductor die of one of the previous claims, wherein:
one of the first interconnect circuit and the second interconnect circuit is configured to have a power level that is greater than a power level of the other one of the first interconnect circuit and the second interconnect circuit.

15. The semiconductor die of one of the previous claims, wherein:
in accordance with selection of the first interface type, the one or more first signaling components are configured to electrically and mechanically connect to a package interconnect located outside the semiconductor die, and the one or more second signaling components are configured to mechanically connect to the package interconnect and to be electrically isolated from the package interconnect;
in accordance with selection of the second interface type, the one or more first signaling components are configured to mechanically connect to the package interconnect and to be electrically isolated from the package interconnect, and the one or more second signaling components are configured to electrically and mechanically connect to the package interconnect; and
the one or more first signaling components and the one or more second signaling components are electrically and mechanically coupled to the set of circuit components regardless of selection of the first interface type or the second interface type.
